# FASCICULE DE BREVET EUROPEEN

(11) **EP 1 972 002 B1**
(45) Date de publication et mention de la délivrance du brevet: **08.04.2009**
(21) Numéro de dépôt: 06830329.6
(22) Date de dépôt: 04.12.2006
(51) Int. Cl.: H01L 21/20, C30B 25/18, C30B 33/00

(54) **PROCEDE DE REALISATION SIMPLIFIEE D'UNE STRUCTURE EPITAXIEE**
VEREINFACHTES VERFAHREN ZUM HERSTELLEN EINER EPITAXIAL GEWACHSENEN STRUKTUR
SIMPLIFIED METHOD OF PRODUCING AN EPITAXIALLY GROWN STRUCTURE

(30) Priorité: 27.12.2005 FR 0554107
(43) Date de publication de la demande: 24.09.2008
(73) Titulaire: COMMISSARIAT A L'ENERGIE ATOMIQUE, 75015 Paris (FR)
(72) Inventeur: FOURNEL, Franck, F-38190 Villard-Bonnot (FR); MORICEAU, Hubert, F-38120 Saint Egreve (FR)
(74) Mandataire: Ilgart, Jean-Christophe
(86) Numéro de dépôt international: PCT/EP2006/069263
(87) Numéro de publication internationale: WO 2007/074027

(56) Documents cités:
- FR-A- 2 766 620
- FR-A- 2 819 099
- US-A1- 2002 111 044

## Description

### DOMAINE TECHNIQUE

La présente invention est relative à un procédé de réalisation d'une structure épitaxiée. On rappelle que l'épitaxie est une technique de croissance de cristaux utilisée pour former, à la surface d'un substrat cristallin d'accueil des couches dont les axes cristallins sont en relation avec les axes cristallins du substrat d'accueil. On parle d'hétéroépitaxie si le matériau déposé est d'une autre espèce chimique que celle du substrat d'accueil. Des substrats ainsi revêtus ont un grand intérêt pour la fabrication de dispositifs semi-conducteurs, optiques ou optoélectroniques. L'optimisation de la croissance cristalline des couches permet d'améliorer la performance de ces dispositifs.

### ÉTAT DE LA TECHNIQUE ANTÉRIEURE

La réalisation d'un dépôt par hétéroépitaxie sur un substrat engendre des dislocations de désaccord de maille (connu sous la dénomination anglo-saxonne de misfit) à partir d'une certaine épaisseur de couche déposée dite épaisseur critique. Cette épaisseur dépend de la différence des paramètres de maille entre le matériau épitaxié et celle du substrat d'accueil. On peut se référer par exemple à l'article de J.W. Matthews et A.E. Blakeslee, « Defects in epitaxial multilayers » Journal of Crystal Growth n°27, pages 118-125, 1974. Les paramètres de maille sont les dimensions latérales de la cellule élémentaire décrivant le matériau cristallin.

De nombreuses méthodes existent pour atténuer cet inconvénient. Parmi celles-ci une méthode consiste au préalable à faire d'abord croître par épitaxie des colonnes (quelquefois appelés îlots dans la littérature) espacées les unes des autres sur le substrat d'accueil. L'avantage en est que le matériau épitaxié en poussant sous forme de colonnes peut relaxer sa contrainte sur la surface libre du substrat d'accueil. Par exemple dans le cas d'une croissance en compression d'une colonne sur un substrat, la colonne va progressivement s'évaser, son diamètre augmentant pour relaxer la contrainte au sein du matériau déposé. Inversement dans le cas d'une croissance en extension d'une colonne, celle-ci va progressivement se rétrécir, son diamètre tendant à diminuer pour relaxer sa contrainte. Simultanément à la relaxation de contrainte, il se produit une croissance latérale qui tend à augmenter en permanence le diamètre des colonnes. Ainsi, à force de s'évaser, les colonnes finissent par se rejoindre pour former une couche continue. On peut modifier les conditions de dépôt pour favoriser la croissance latérale et la coalescence, c'est-à-dire la soudure des colonnes venant en contact. Si l'espacement des colonnes est approprié, au moment où les colonnes se rejoignent, le matériau épitaxié aura relaxé tout ou partie de sa contrainte et aura ainsi retrouvé tout au partie de son paramètre de maille naturel. Le niveau de relaxation peut être quantifié par le taux de relaxation correspondant au rapport entre le niveau de contrainte de départ et celui obtenu après l'épitaxie en l'absence d'apparition de défauts. En continuant le dépôt par épitaxie, on obtient une couche de matière qui ne possède que peu voire pas de dislocations puisqu'on s'est affranchi de tout ou partie des contraintes de désaccord de paramètres de maille. L'épaisseur critique que l'on peut obtenir pour cette couche est supérieure à celle que l'on aurait obtenu par épitaxie standard ou conventionnelle sur toute la surface du substrat d'accueil.

Une technique employée pour obtenir les colonnes consiste à délimiter à la surface du substrat d'accueil des germes de croissance localisés, ces germes de croissance ayant une surface appropriée qui correspond à celle de la base des colonnes. Pour cela on peut disposer sur la surface d'accueil du substrat un masque de croissance, ce masque étant doté d'ouvertures mettant à nu le substrat d'accueil. Le substrat à nu au fond des ouvertures forme les germes de croissance. En variante, il est possible comme décrit dans l'article « Nanoheteroepitaxy : nanofabrication route to improved epitaxial growth » D. Zubia et al, Journal of Vac. Sci. Technol. B 18(6), Nov./Dec. 2000, pages 3514-3520, d'utiliser une couche mince cristalline solidaire d'un substrat présentant en surface un matériau sur lequel la croissance épitaxiale n'est pas possible. Dans l'article il s'agit de silice. La couche mince est gravée par lithographie et gravure ionique (connue sous l'acronyme anglo-saxon RIE pour reactive ionic etching) pour mettre à nu localement le substrat et délimiter ainsi dans la couche mince des plots formant les germes de croissance. On peut ensuite commencer l'épitaxie pour faire croître le matériau à épitaxier à partir des germes. Le matériau à épitaxier ne se déposant qu'au niveau des germes de croissance, la croissance s'effectue sous forme de colonnes.

Les problèmes engendrés par cette méthode sont qu'elle nécessite une étape de lithographie pour graver le masque ou la couche cristalline et ainsi définir les germes de croissance. Or ces germes de croissance doivent être réalisés à l'échelle nanométrique, leur taille typique étant comprise entre un et quelques dizaines de nanomètres, et doivent être répartis de manière très régulière à la surface du substrat d'accueil, la distance entre ces germes étant de l'ordre de la dizaine à quelques centaines de nanomètres. Actuellement, il n'est pas connu de méthode satisfaisante pour réaliser de manière collective et ordonnée de tels germes de croissance à l'échelle d'un substrat de diamètre pouvant aller jusqu'à 300 millimètres et plus.

### EXPOSÉ DE L'INVENTION

La présente invention vise à proposer un procédé de réalisation d'une structure épitaxiée par croissance de colonnes à l'échelle nanométrique sans à avoir recours à une étape de lithographie à l'échelle nanométrique. Ce substrat est obtenu de manière économique et peut posséder une grande surface. La position et la géométrie des colonnes sont obtenues avec grande précision.

Plus précisément, la présente invention est un procédé de réalisation d'une structure épitaxiée consistant à déposer un matériau par croissance épitaxiale colonnaire sur une face cristalline d'un substrat, à poursuivre le dépôt jusqu'à ce que les colonnes se rejoignent et conduisent à une couche continue. Il consiste à pourvoir la face du substrat d'un réseau périodique de saillies à l'échelle nanométrique, chaque saillie présentant une zone d'appui pour une colonne, et étant obtenue directement ou indirectement à partir d'un réseau de défauts cristallins et/ou de champs de contraintes créé au sein d'une zone cristalline située au voisinage d'une interface de collage entre deux éléments comprenant du matériau cristallin et ayant des réseaux cristallins décalés en rotation et/ou en flexion et/ou présentant un désaccord de paramètres de maille à l'interface, aptes à conditionner la période du réseau de saillies, la période du réseau, la hauteur des saillies et la taille de leur zone d'appui étant ajustées de manière que la couche continue ait une épaisseur critique supérieure à celle obtenue lors d'une épitaxie réalisée en l'absence des saillies.

Il est préférable que la période du réseau, la hauteur des saillies et la taille de leur zone d'appui soient ajustées de manière que le matériau déposé par épitaxie ait retrouvé son paramètre de maille naturel au moment où les colonnes se rejoignent.

Le substrat dont la face est dotée du réseau de saillies peut être réalisé à partir des deux éléments collés, en amincissant l'un des éléments jusqu'à faire apparaître un relief de surface correspondant réseau de défauts cristallins et/ou de champs de contraintes, ce relief formant alors le réseau de saillies, ce réseau de saillies étant supporté par l'autre élément.

L'amincissement peut comprendre au moins une étape choisie parmi une abrasion mécanique, une abrasion chimique, une rectification, un traitement sacrificiel.

Le procédé peut comprendre en outre une étape de traitement du réseau de saillies de manière à ajuster la hauteur et/ou la taille de la zone d'appui des saillies et/ou à modifier le paramètre de maille du matériau constitutif des saillies.

L'étape de traitement du réseau de saillies peut comprendre une étape d'implantation.

L'étape d'amincissement et/ou de traitement du réseau de saillies peut comprendre au moins une étape d'attaque chimique et/ou d'attaque électrochimique et/ou d'attaque mécanique et/ou d'attaque ionique et/ou d'attaque photochimique et/ou un dépôt.

L'étape d'amincissement et/ou de traitement du réseau de saillies peut comprendre l'apport d'un budget thermique, sous des atmosphères diverses, oxydantes ou réductrices.

Pour former les éléments, on peut prélever dans une même structure cristalline au moins deux parties, ces deux parties contribuant à la formation de l'interface de collage.

Lors du collage les deux parties ont de préférence leurs réseaux cristallins décalés en rotation et/ou en flexion d'un angle prédéterminé.

La structure cristalline comporte de préférence des marques de repérage qui sont reportées dans les deux parties lors du prélèvement, ces marques de repérage étant utilisées pour ajuster l'angle de décalage.

Au moins un des éléments est un substrat composite formé d'un empilement d'un support, d'une couche d'arrêt à l'amincissement du support et d'au moins une couche cristalline.

L'étape d'amincissement concerne de préférence le substrat composite.

Le substrat composite peut être un substrat SOI.

La partie prélevée dans le substrat composite comprend au moins la couche cristalline.

Le collage peut se faire par adhésion moléculaire.

Il est possible de faire varier la composition du matériau déposé pendant le dépôt par épitaxie.

En variante, le substrat dont la face est pourvue du réseau de saillies peut être réalisé par duplication d'un substrat mère dont une face comporte un réseau de saillies à l'échelle nanométrique, le substrat mère étant obtenu à partir des deux éléments collés et par au moins une étape d'amincissement de l'un des éléments conduisant directement ou indirectement à une révélation du réseau de défauts cristallins et/ou de champs de contraintes, ce réseau de défauts cristallins et/ou de champs de contraintes formant le réseau de saillies.

La duplication peut se faire par nanoimpression à partir d'un moule complémentaire du substrat mère.

Quant au moule, il peut être obtenu par nanoimpression à partir du substrat mère.

La présente invention concerne également une structure épitaxiée comportant des colonnes (4) de matériau épitaxié s'évasant de manière à se rejoindre et à former une couche continue. Chaque colonne repose sur une zone d'appui d'une saillie d'un réseau périodique de saillies à l'échelle nanométrique dont est dotée une face d'un substrat, ces saillies provenant directement ou indirectement d'un réseau de défauts cristallins et/ou de champs de contraintes, les saillies du réseau ayant une période, une hauteur et une taille de zone d'appui ajustées de manière à ce que la couche continue ait une épaisseur critique supérieure à celle obtenue lors d'une épitaxie réalisée en l'absence des saillies.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
les figures 1A à 1G montrent des étapes de réalisation d'une structure épitaxiée par un premier exemple du procédé selon l'invention ;
les figures 2A à 2K montrent des étapes de réalisation d'une structure épitaxiée par un autre exemple du procédé selon l'invention ;
les figures 3A à 3F montrent des étapes de réalisation d'une structure épitaxiée par encore un autre exemple du procédé selon l'invention ;
les figures 4A à 4D montrent l'utilisation d'un substrat composite dans l'exemple des figures 2 au lieu d'un substrat massif.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

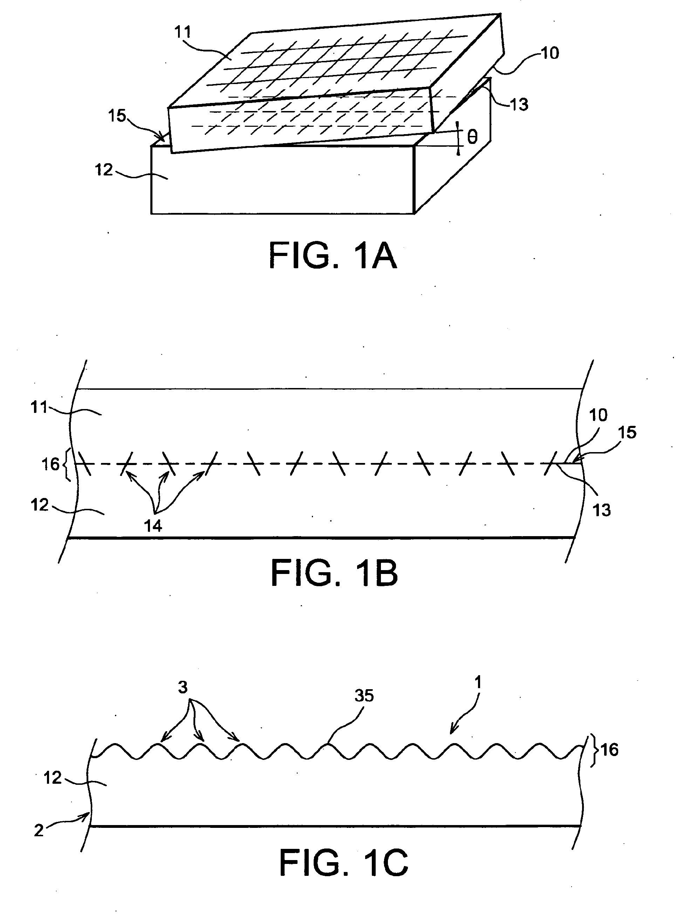

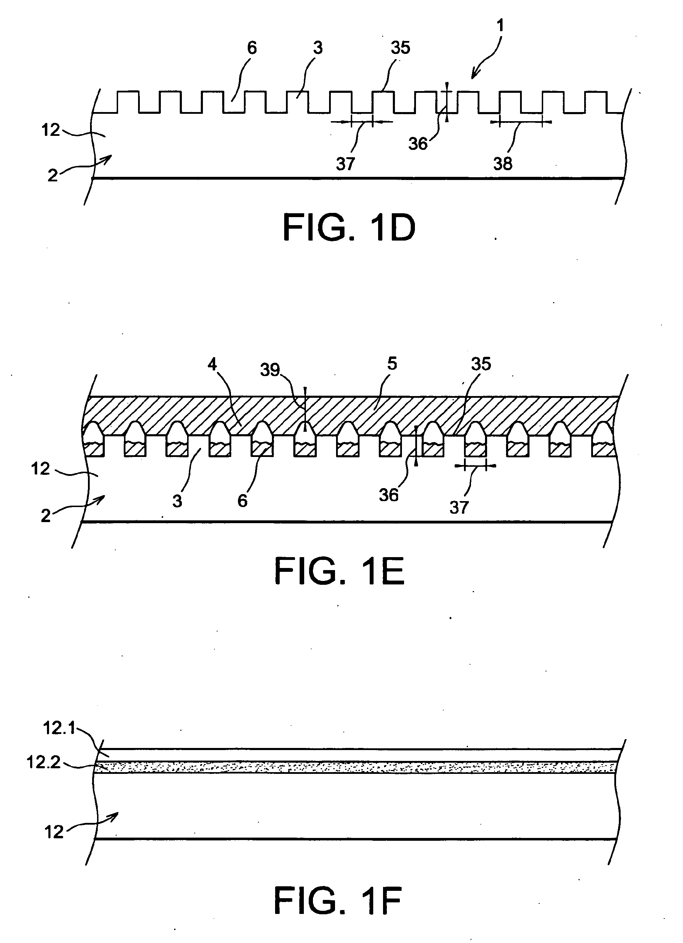

On peut se référer aux figures 1A à 1G qui montrent différentes étapes d'un premier exemple de procédé de réalisation d'une structure épitaxiée selon l'invention. Le procédé objet de l'invention consiste à réaliser la structure épitaxiée en débutant le dépôt de le matériau à épitaxier par une croissance colonnaire sur une surface libre cristalline 1 d'un substrat 2 doté d'un réseau de saillies 3 à une échelle nanométrique comme illustré sur la figure 1D. Ces saillies ont une taille de l'ordre de 1 à quelques dizaines de nanomètres, typiquement 20 nanomètres. Ce substrat 2 peut être appelé substrat nanostructuré. Comme illustré à la figure 1E, les colonnes 4 prennent appui sur ces saillies 3 et plus précisément sur une zone d'extrémité 35 des saillies encore appelée par la suite zone d'appui. Ces zones d'appui 35 forment le soubassement des colonnes 4. Ce dépôt se poursuit, comme dans l'art antérieur, jusqu'à ce que les colonnes 4 se rejoignent et forment une couche continue 5 uniforme. Les saillies ont des dimensions et le réseau de saillies une période adaptés pour que le matériau que l'on dépose ait un taux de relaxation de ses contraintes souhaité, par exemple le plus grand possible, au moment de la coalescence, c'est-à-dire au moment de la soudure des colonnes 4 entre elles. Par dimension on entend leur hauteur 36 et la taille de la zone d'appui 35. La couche continue uniforme 5 qui se forme lorsque l'on continue le dépôt par épitaxie aura donc également des contraintes tout ou partie relaxées. Elle aura une épaisseur critique 39 supérieure à celle de la couche que l'on aurait obtenue par épitaxie conventionnelle sans croissance colonnaire préalable.

On va voir maintenant comment sont obtenues les saillies 3 à l'échelle nanométrique. Il peut s'agir par exemple de volumes sensiblement parallélépipédiques dont les dimensions sont de l'ordre du ou de quelques dizaines de nanomètres.

Plusieurs manières simples d'obtenir ce réseau de saillies 3 à l'échelle nanométrique sont expliquées dans la demande de brevet FR-A-2 766 620. On peut par exemple commencer par coller par adhésion moléculaire, une face 10 en matériau cristallin d'un premier élément 11 contre une face 13 en matériau cristallin d'un second élément 12 en faisant en sorte que les deux faces 10, 13 présentent des réseaux cristallins décalés angulairement d'un angle θ déterminé et un angle d'inclinaison résultant entre les axes verticaux des réseaux cristallins ou angle de flexion (connu sous la dénomination anglo-saxonne d'angle de « tilt ») nul. Grâce à l'adhésion moléculaire, il se crée des liaisons covalentes entre les deux réseaux cristallins des faces à assembler.

Cet angle de décalage en rotation θ, est connu sous la dénomination anglo-saxonne d'angle de « twist », cette dénomination sera employée par la suite.

Dans le cas d'un collage entre deux plaquettes de silicium de direction cristalline <001> par exemple, l'introduction d'un angle de «twist » θ donné produit un réseau carré de dislocations. L'introduction d'un angle de « tilt » produirait quant à elle un réseau unidimensionnel de dislocations.

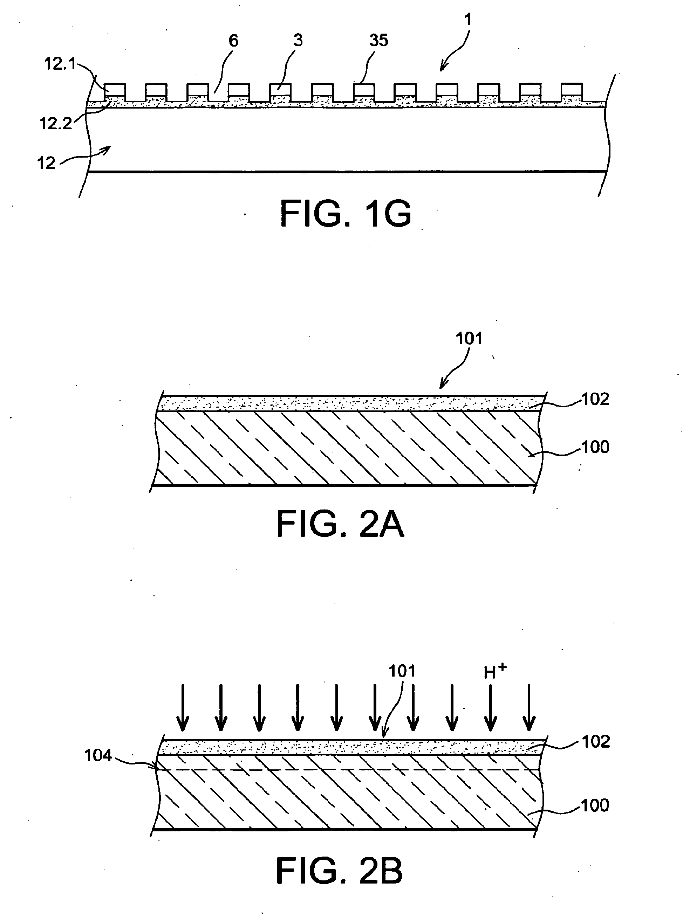

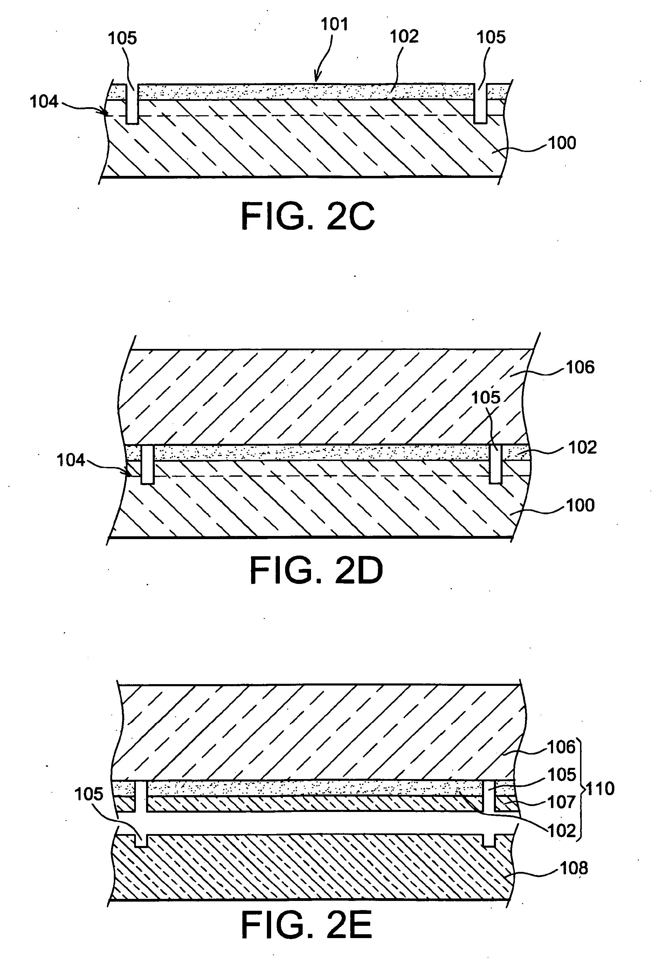

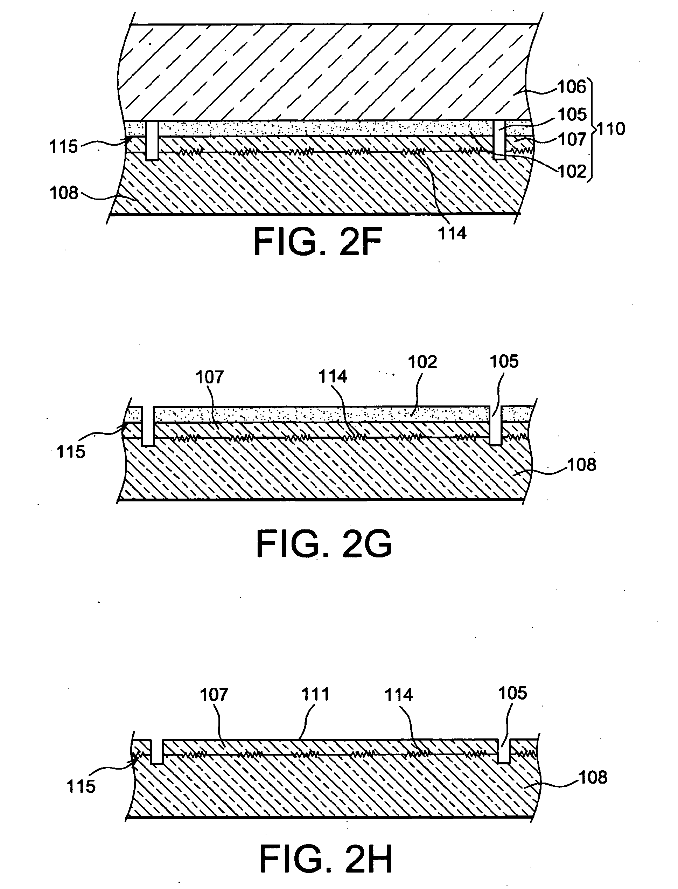

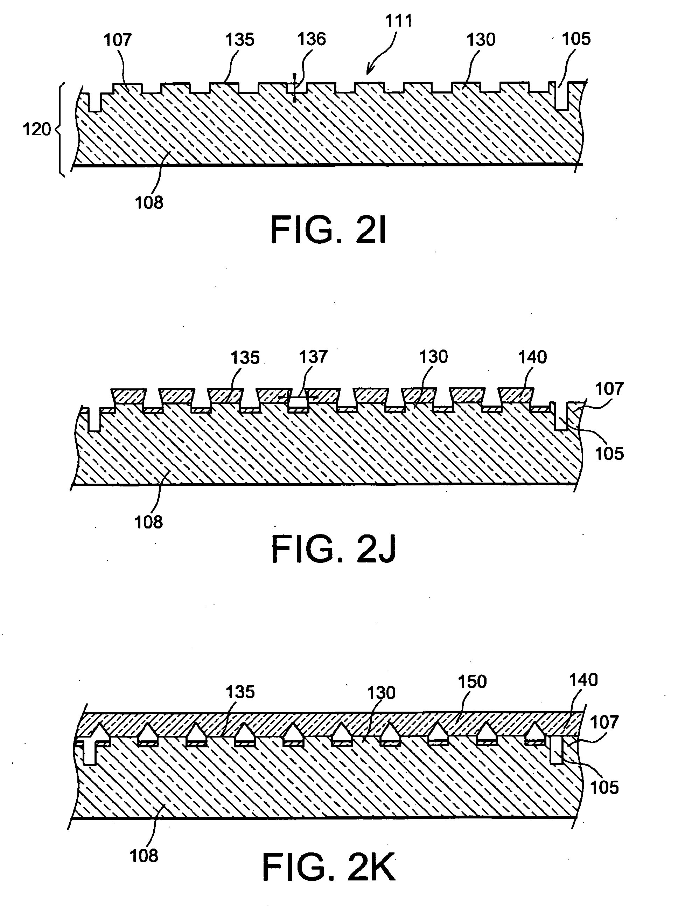

La figure 1A montre la mise en contact des deux éléments 11, 12 et illustre l'angle de « twist » θ et les réseaux cristallins des deux éléments 11, 12. Ce collage par adhésion moléculaire se fait de manière que des liaisons interatomiques s'établissent entre les deux éléments 11, 12 et provoquent, en raison du décalage angulaire, la formation d'un réseau périodique de défauts cristallins et/ou de champs de contraintes 14 au sein d'une zone cristalline 16 située au voisinage de l'interface 15 de collage. La figure 1B illustre en coupe la structure obtenue après le collage et illustre le réseau de défauts cristallins et/ou de champs de contraintes 14 obtenu. En variante ou en complément, il est possible également de moduler l'angle de « tilt » et/ou le désaccord de maille entre les deux réseaux pour obtenir d'autres réseaux de défauts cristallins et/ou de champs de contraintes.. On suppose que dans l'exemple des figures 1 et 2 on aura minimisé l'angle de « tilt » et le désaccord de maille de sorte que le réseau créé dépend essentiellement de l'angle de « twist ».

Le collage se fait à chaud ou bien à froid. Le scellement sera, de préférence, renforcé par un traitement thermique pour obtenir ce réseau de défauts cristallins et/ou de champs de contraintes 14. Ces défauts cristallins peuvent être des dislocations. La zone cristalline 16 a une faible épaisseur (quelques dizaines de nanomètres) et est localisée autour l'interface 15. Ce réseau 14 de défauts cristallins et/ou de champs de contraintes est à l'origine du réseau de saillies à l'échelle nanométrique.

La période du réseau de défauts cristallins et/ou de champs de contraintes dépend de l'angle de «twist» θ des réseaux cristallins des deux éléments 11, 12. On peut se référer à la figure 1A.

Subséquemment, on amincit l'un des deux éléments assemblés 11 12, par exemple par rectification, par abrasion mécanique ou chimique, de sorte que la présence du réseau 14 de défauts cristallins et/ou de champs de contraintes induise au niveau de la surface libérée des reliefs en saillie et en creux. Les creux peuvent correspondre aux défauts cristallins et les saillies au matériau cristallin de la zone cristalline 16 ou réciproquement. C'est sur ces saillies 3 et plus particulièrement sur leur zone d'extrémité ou d'appui 35 que l'on va faire croître les colonnes. On peut se référer à la figure 1C qui montre le réseau de saillies qui a été induit. La surface structurée obtenue peut se situer dans le premier élément 11, à cheval sur les deux éléments 11, 12 comme illustré sur la figure 1C ou dans le second élément 12 si l'élément 11 a totalement été éliminé.

Un traitement de surface optionnel peut être réalisé ensuite pour accentuer encore plus le relief en surface comme illustré sur la figure 1D et ajuster la hauteur 36 des saillies 3 et la taille de leur zone d'appui 35. On peut par exemple utiliser un bain chimique pour attaquer sélectivement les défauts cristallins 14, sans attaquer leur voisinage. On obtient alors un substrat nanostructuré, c'est à dire doté d'un réseau de saillies 3 séparées par des creux 6, ces creux et ces saillies étant dimensionnés à l'échelle nanométrique. L'angle de « twist » entre les deux éléments 11, 12 conditionne la période du réseau de défauts cristallins et/ou du champs de contraintes comme vu précédemment et donc également la période 38 entre les saillies 3. Avec du silicium comme matériau cristallin, il est possible de moduler et de contrôler très finement cette période 38, comprise par exemple entre quelques nanomètres et quelques centaines de nanomètres avec une précision de l'ordre de quelques dixièmes de nanomètres si l'ajustement de l'angle de «twist» s'effectue avec une précision de l'ordre du centième de degré. Cette précision peut être obtenue comme enseigné dans la demande de brevet FR-A1-2 819 099 en prélevant les deux éléments 11, 12 dans une même structure initiale et en dotant au préalable cette structure d'une ou plusieurs marques de repérage avant la séparation des deux éléments. Il suffit alors de contrôler de manière précise les positions relatives angulaires des deux éléments avant des les assembler et cela se fait grâce aux marques de repérage. Cette méthode sera décrite ultérieurement aux figures 2. D'autres méthodes existent bien sûr, mais il faut connaître aux préalable les directions cristallines des réseaux cristallins présentées par les faces 10, 13 à assembler des éléments 11, 12. Ces méthodes ne conduisent pas toujours à une aussi bonne précision et surtout ne permettent pas en général de minimiser l'angle de « tilt », ce qui provoque l'apparition d'un réseau unidimensionnel de dislocations supplémentaire qu'il faut gérer et qui interagit avec le réseau de défauts cristallins et/ou de champs de contraintes généré par l'angle de « twist ».

Cette période 38 est un des éléments qui permet de contrôler le moment où les colonnes vont se rejoindre en fonction de l'épaisseur de matière épitaxiée. Elle dépend de l'angle de « twist ».

L'opération de révélation du réseau de saillies 3 et celle éventuelle de traitement pour accentuer le relief des saillies 3 permettent quant à elles de faire varier la hauteur 36 et/ou la taille de la zone d'appui 35 des saillies 3. La période 38 du réseau étant fixée par l'angle de « twist », l'espacement 37 entre les saillies évolue en même temps que la taille de la zone d'appui 35.

En variante, l'élément qui n'est pas aminci, dans l'exemple l'élément 12, pourrait être formé d'un empilement avec un film 12.1 en matériau cristallin recouvrant une couche d'arrêt à la gravure 12.2 comme illustré à la figure 1F. L'assemblage de cet élément avec l'autre pourra se faire comme décrit précédemment. La couche d'arrêt 12.2 pourra être réalisée par exemple en oxyde de silicium, en nitrure de silicium, en silicium amorphe. Le film 12.1 pourra lui être choisi dans l'un des matériaux cités plus loin en tant que matériau cristallin d'accueil, par exemple en silicium.

L'avantage d'utiliser un élément 12 tel qu'illustré à la figure 1F est que lors du traitement, on va mettre à nu localement la couche d'arrêt 12.2, au niveau des creux 6 et que de ce fait on obtiendra en surface deux matériaux distincts dont avantageusement un seul permettra la croissance épitaxiale. Un deuxième avantage est de pouvoir contrôler indépendamment la hauteur et les dimensions latérales des saillies.

La couche d'arrêt 12.2 peut n'être que partiellement attaquée ou ne pas être attaquée. L'attaque peut être une attaque sèche ou humide, chimique, ionique, électrochimique, photochimique, thermique, sous atmosphère réductrice ou oxydante. L'attaque peut par exemple avoir une vitesse très faible dans la couche d'arrêt 12.2 par rapport à celle qui existe dans le matériau cristallin pour ajuster les dimensions latérales des saillies 7. On peut se référer à la figure 1G.

Pour accroître la hauteur des saillies, la couche d'arrêt pourra être gravée sélectivement vis-à-vis du matériau du film 12.1 de même que la couche sous-jacente.

La croissance épitaxiale se fait sous forme colonnaire sur la zone d'appui 35 des saillies 3 mais bien sûr également dans les creux. On cherche en ajustant les dimensions des saillies à ce que les creux ne soient pas totalement emplis de matériau. Avec des saillies 3 suffisamment hautes et proches, par exemple avec une hauteur 36 de l'ordre de 10 nanomètres et un espacement 37 de l'ordre de 3 nanomètres, la croissance colonnaire est suffisamment découplée de la croissance dans les creux 6 pour permettre la relaxation du matériau formant les colonnes 4 et la formation de la couche continue uniforme dont les contraintes sont relaxées.

En jouant sur les trois paramètres qui sont la hauteur 36 des saillies, la taille de leur zone d'appui 35 et leur période 38, il est possible de faire croître des matériaux différents, en paramètre de maille, sur des substrats 2 d'un matériau donné dotés d'un réseau de saillies adapté.

Après épitaxie, on peut obtenir une couche continue 5 d'épaisseur et de qualité cristalline requise. L'épaisseur critique 39 pour cette couche 5 est toujours supérieure à celle que l'on aurait obtenu avec un substrat d'accueil qui ne serait pas structuré. Si on dépasse cette épaisseur critique 39, le taux de défauts dans la couche sera inférieur à celui qui aurait été obtenu pour une couche de même épaisseur sans structurer le substrat d'accueil.

A titre d'exemple le matériau cristallin d'accueil, c'est-à-dire celui des saillies ou bien souvent celui du substrat 2 doté des saillies peut être choisi parmi le silicium Si, le germanium Ge, l'arséniure de gallium GaAs, le carbure de silicium SiC, le phosphure d'indium InP, le saphir, le diamant, la zircone, l'oxyde de magnésium MgO, ces matériaux étant pris seuls ou en combinaison. Le matériau déposé par épitaxie peut être choisi parmi le silicium Si, le germanium Ge, le nitrure de gallium GaN , le diamant, le carbure de silicium SiC, le phosphure d'indium InP, l'arséniure de gallium GaAs, l'arséniure d'indium InAs, le silicium-germanium SiₓGe₁₋ₓ, les composés III-V par exemple de type InGaAs ou les composés II-VI par exemple de type CdTe, ces matériaux étant pris seuls ou en combinaison. Le matériau de la couche épitaxiée dans sa partie continue est en général différent de celui du substrat d'accueil 2.

Il peut être intéressant de faire varier la composition du matériau déposé pendant l'épitaxie. Ainsi sur un substrat structuré de silicium, on pourra faire croître du SiₓGe₁₋ₓ avec x variant entre une première valeur α telle que 0 < α < 1 et une seconde valeur β telle que 0 ≤ β < 1 (avantageusement β=0). La variation pourra ou non être linéaire. On pourra poursuivre la croissance épitaxiale par du germanium. A épaisseur critique équivalente pour la couche de germanium, il faudra une épaisseur beaucoup plus petite pour la couche épitaxiée de SiₓGe₁₋ₓ avec x variable sur les zones d'appui 35, que si l'épitaxie de SiₓGe₁₋ₓ (avec x variable) se faisait sur un substrat qui n'était pas structuré.

Un avantage du procédé selon l'invention par rapport à l'art antérieur est que l'on n'a plus besoin d'étape de lithographie ni de masque dans lequel on avait du mal à graver des ouvertures avec une densité et des dimensions telles que ces ouvertures conduisent à une couche épitaxiée dont les contraintes sont bien relaxées. Avec le procédé de l'invention, puisqu'on peut obtenir une densité de saillies plus importante que la densité d'ouvertures gravées dans le masque, et ce avec une période contrôlée très précisément et puisque on peut obtenir des saillies ayant une zone d'appui qui est plus petite que celle des ouvertures du masque, on va obtenir plus facilement une meilleure relaxation des contraintes de la couche épitaxiée. La couche épitaxiée formée 5 pourra avoir des contraintes aussi minimisées que possible et donc un taux de relaxation de ses contraintes le plus grand possible. La croissance de cette couche pourra se faire sans relaxation plastique et donc en évitant la formation de défauts qui apparaissent traditionnellement à cause de cette relaxation plastique. On pourra néanmoins choisir si on le souhaite de dépasser l'épaisseur critique : on obtiendra alors une couche présentant des défauts mais en quantité moindre qu'une couche que l'on aurait obtenu sans l'invention. Il est possible que le matériau de la couche épitaxiée ait un paramètre de maille très différent, par exemple différent de plusieurs pourcents, du paramètre de maille du matériau du substrat 12 d'accueil doté du réseau de saillies.

Un autre avantage du procédé de l'invention est que la formation des saillies se fait de manière collective avec des dimensions très petites, de manière très précise et avec une grande régularité, quelle que soit la taille des éléments assemblés. Ce procédé s'applique avec les mêmes contraintes aussi bien aux substrats de 100 millimètres de diamètre qu'aux substrats plus grands par exemple de 150, 200 ou 300 millimètres de diamètre. Ces dimensions sont des dimensions standard industrielles des substrats de silicium. Avec le procédé de l'art antérieur, la gravure du masque avait recours à des techniques de lithographie qui sont plus longues et plus coûteuses avec de grands substrats qu'avec de plus petits et qui ne sont pas toujours disponibles pour des substrats de petites dimensions par exemple inférieures à 50 millimètres.

On va maintenant, en se référant aux figures 2A à 2K, décrire un autre exemple de procédé selon l'invention qui se base sur l'enseignement de la demande de brevet FR-A-2 819 099 et de la demande de brevet FR-A-2 815 121. Ce procédé consiste à assembler deux éléments en les orientant l'un par rapport à l'autre en rotation de manière extrêmement précise, cette précision étant due au fait que les deux éléments ont été prélevés dans un même substrat cristallin, par exemple semi-conducteur, qui est doté d'une ou plusieurs marques de repérage de manière que les éléments prélevés portent ces marques de repérage. Ce procédé a l'avantage de minimiser voire d'annuler l'angle de flexion. Comme dans la demande de brevet FR-A-2 815 121, l'un des éléments est inclus dans un substrat composite formé d'un support, d'une couche d'arrêt à l'amincissement du support et d'au moins la couche cristalline formant l'élément à assembler. Il peut s'agir par exemple d'un substrat semi-conducteur sur isolant, connu sous la dénomination SOI. Un substrat SOI peut comporter deux couches de matériau semi-conducteur situées de part et d'autre d'une couche d'isolant. L'une des couches de matériau semi-conducteur est moins épaisse que l'autre. La couche plus épaisse correspond au support du substrat composite, la couche d'isolant à la couche d'arrêt à l'amincissement du support, la couche moins épaisse à l'élément à assembler. C'est par la couche la moins épaisse que le substrat semi-conducteur sur isolant sera assemblé à l'autre élément.

Dans cet exemple, on part d'un substrat de base 100 de matériau semi-conducteur cristallin, par exemple du silicium, présentant une face libre 101 orientée dans la direction <001>. Ce substrat peut avoir un diamètre 100 millimètres, mais on pourrait utiliser un substrat plus petit ou plus grand de 150, 200 ou même 300 millimètres de diamètre. Le choix de cette orientation <001> permet d'obtenir un réseau de saillies ayant une symétrie d'ordre de 4. Il est bien sûr possible d'utiliser un substrat de base dont la surface aurait une autre orientation cristalline, par exemple, l'orientation cristalline <111> qui conférerait au réseau de saillies une symétrie d'ordre 3.

On va traiter ce substrat 100 de manière à pouvoir en prélever deux parties ayant des surfaces cristallines qui seront collées l'une à l'autre par la suite. On peut commencer par former une couche d'oxyde 102 en oxydant thermiquement la face libre 101. Cette couche d'oxyde 102 peut avoir une épaisseur d'environ 400 nanomètres. Cette étape est illustrée sur la figure 2A. La couche d'oxyde 102 servira ultérieurement de couche d'arrêt à l'amincissement.

On va ensuite fragiliser le substrat de base 100 au moyen d'ions implantés par exemple des ions d'hydrogène ou de toute autre espèce gazeuse, apte à générer une zone de fragilisation enterrée et capable d'induire ultérieurement une fracture au niveau de cette zone de fragilisation. Cette zone de fragilisation 104 va prendre la forme d'un plan situé dans le silicium du substrat 100 de base, sous la couche d'oxyde 102 à une distance de l'ordre de la profondeur d'implantation. L'implantation se fait depuis la surface libre 101 de la couche d'oxyde 102. L'énergie d'implantation peut être par exemple, pour un substrat de silicium, d'environ 76 keV et la dose d'ions hydrogène valoir environ 6.10¹⁶ atomes/cm². Dans ces conditions, pour une couche d'oxyde 102 de 400 nanomètres, la zone de fragilisation 104 se trouve à environ 760 nanomètres de la surface libre de la couche d'oxyde 102. On se réfère à la figure 2B.

On réalise ensuite une ou plusieurs marques de repérage 105, par exemple par photolithograhie et gravure chimique, ionique ou autre dans la couche d'oxyde 102 et dans le semi-conducteur sous-jacent du substrat de base 100, ces marques de repérage 105 empiétant dans le substrat de base 100 au-delà de la zone de fragilisation 104 par rapport à la couche d'oxyde 102. D'autres méthodes de gravure de ces marques de repérage pourraient être utilisées, par exemple à l'aide d'un laser. Les marques de repérage 105 pourraient traverser totalement le substrat de base 100. On peut se référer à la figure 2C qui illustre ces marques de repérage 105. Ces marques de repérage 105 peuvent être configurées comme expliqué dans la demande de brevet FR-A-2 819 099 et prendre la forme d'échelles graduées telles des rapporteurs. Les graduations peuvent indiquer par exemple les degrés, les dixièmes de degrés, les centièmes de degrés ou les millièmes de degrés. Lorsqu'il y a deux marques de repérage, elles peuvent être diamétralement opposées sur le substrat de base 100.

On assemble ensuite, à la figure 2D, la structure de la figure 2C sur un substrat auxiliaire 106, par exemple en silicium. Cet assemblage se fait par la face portant la couche d'oxyde 102. La méthode d'assemblage peut être un collage moléculaire hydrophile.

On provoque ensuite une fracture le long du plan de la zone fragilisée 104, par exemple par un traitement thermique, par exemple à 500°C pendant une heure. Ce traitement thermique a aussi comme avantage de renforcer l'adhésion moléculaire. On est alors en présence de deux éléments 110, 108 comme illustré sur la figure 2E. Dans notre exemple, l'un des éléments 110 est un substrat de type semi-conducteur sur isolant et dans le cas présent silicium sur isolant, il est formé de l'empilement du substrat auxiliaire 106, de la couche d'oxyde 102 et d'un film mince cristallin de silicium 107 prélevé dans le substrat de base 100 grâce à la fracture. L'autre élément 108 correspond à ce qui reste du substrat de base 100. Les deux éléments 108, 110 sont munis tous les deux des marques de repérage 105 et comportent une partie cristalline 107, 108 qui provient du substrat de base 100.

L'élément 110, qui est dans l'exemple est de type substrat SOI, peut être soumis à un traitement de recuit, d'oxydation et de polissage du côté du film mince 107 qui comporte les marques de repérage 105 sans bien sûr faire disparaître les marques de repérage 105. On s'arrange pour qu'en fin de traitement, le film mince de silicium 107 conserve une épaisseur par exemple de l'ordre de 100 nanomètres. L'autre élément 108 qui, dans l'exemple, est massif peut être soumis à un polissage de sa face portant les marques de repérage 105 afin d'obtenir une surface polie compatible avec le collage ultérieur, sans bien sûr faire disparaître les marques de repérage 105. Ce sont ces deux parties cristallines 108, 107 que l'on va coller l'une à l'autre, au niveau d'une interface de collage, par adhésion moléculaire, par exemple, hydrophobe en introduisant un angle de « twist » déterminé de façon très précise, grâce à la présence des marques de repérage 105 sur les deux parties cristallines 107, 108. La valeur de l'angle de « twist » peut être, par exemple de 0,44° ou de 1,1°. Ces valeurs vont créer un réseau de défauts cristallins et/ou de champs de contraintes de symétrie 4 et ayant une période respectivement de 50 et 20 nanomètres. On peut se référer à la figure 2F qui illustre l'étape de collage. On procède généralement à ce stade à un traitement thermique de renforcement du collage par exemple à 700°C pendant une heure.

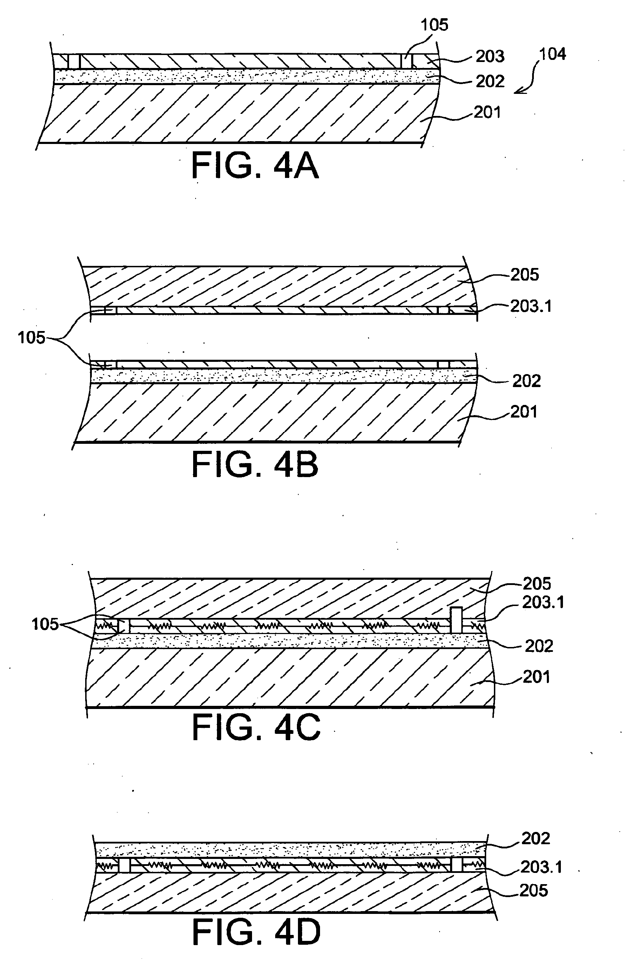

En variante, il serait possible de partir non pas d'un substrat de base massif mais d'un substrat de base composite 200 comme défini précédemment avec un support 201, une couche d'arrêt 202 à l'amincissement du support et au moins une couche cristalline 203 (figure 4A). On prélèverait un film mince cristallin 203.1 de la couche cristalline 203 que l'on reporterait sur un autre support 205 (figure 4B). La structure obtenue pourrait alors être assemblée avec le reste du substrat composite 200 duquel on a prélevé le film mince en introduisant un angle de « twist » déterminé de façon très précise grâce aux marques de repérage 105 que portait initialement le substrat composite 200 (figure 4C).

On va maintenant former le réseau périodique de saillies à l'échelle nanométrique qui va servir de soubassement aux colonnes. On continue la description à partir de la structure obtenue à la figure 2F mais la description pourrait s'appliquer à la structure obtenue à la figure 4C.

Au lieu d'amincir l'un des éléments 11 jusqu'à ce que le réseau de défauts cristallins et/ou de champs de contraintes soit révélé comme on l'a décrit aux figures 1, on va amincir l'un des éléments 110, 108 sans révéler le réseau de défauts cristallins et/ou de champs de contraintes. Dans l'exemple décrit, on va amincir l'élément 110 formé par le substrat semi-conducteur sur isolant. Il est bien sûr possible, en variante, notamment lorsque le substrat de départ est composite comme décrit aux figures 4, d'amincir le substrat 200, à partir du support 201 jusqu'à la couche d'arrêt 202 comme illustré à la figure 4D.

L'amincissement de l'élément 110 consiste à conserver totalement ou en partie le film mince 107 prélevé dans le substrat de base 100 à la figure 2D. Pour obtenir l'amincissement, on va dans un premier temps éliminer le substrat auxiliaire 106 qui formait la partie en silicium la plus épaisse du substrat SOI 110. Cette élimination peut se faire par exemple par une méthode mécanique connue de l'homme de l'art puis par une méthode chimique utilisant par exemple du TMAH (hydroxyde de triméthylamonium). L'attaque chimique s'arrête sur la couche d'oxyde 102. Cette étape est représentée sur la figure 2G.

On élimine ensuite la couche d'oxyde 102 par une attaque, par exemple, au moyen d'une solution aqueuse d'acide fluorhydrique HF. La concentration en acide fluorhydrique peut être de 10%. On procède ensuite à un amincissement du film mince 107, son épaisseur peut par exemple être.réduite à moins de 20 nanomètres.

Cet amincissement peut consister en une attaque chimique et/ou en une oxydation thermique suivie d'une attaque chimique, l'attaque chimique pouvant se faire par exemple au moyen d'une solution aqueuse d'acide fluorhydrique. L'enchaînement de l'oxydation thermique suivie de l'attaque chimique correspond à un traitement sacrificiel. A ce stade, la surface libre 111 du film aminci 107 ne révèle pas la présence du réseau de défauts cristallins et/ou de champs de contraintes 114. On obtient la structure représentée à la figure 2H. L'étape suivante, illustrée à la figure 2I, consiste à traiter le film aminci 107 pour que sa face libre 111 révèle la présence du réseau de défauts cristallins et/ou de champs de contraintes 114 autour de l'interface de collage 115. Ce traitement peut être une attaque chimique qui attaque préférentiellement les zones de contraintes. A l'issue du traitement, on obtient une surface avec un réseau de saillies 130 à l'échelle nanométrique. Cette attaque chimique peut être réalisée à l'aide de solutions chimiques aqueuses à base d'acide fluorhydrique et de trioxyde de chrome CrO₃/HF ; d'acide fluorhydrique et d'acide nitrique HNO₃/HF; d'ions bichromates et d'acide fluorhydrique Cr₂O₇₋₋/HF. On peut rajouter dans ces solutions de l'acide acétique et/ou un alcool tel que l'éthanol ou le propanol et/ou de l'ammoniaque. Pour ajuster notamment la hauteur 136 des saillies et la taille de leur zone d'appui 135, on peut compléter l'étape de révélation par d'autres étapes de traitement de surface tels que d'autres attaques chimiques, des gravures ioniques (RIE), des oxydations et des désoxydations, des attaques électrochimiques, photochimiques, des dépôts de matière etc........On pourra par exemple déposer du germanium, typiquement l'équivalent d'un film de 1 nanomètre. Le dépôt se fera essentiellement sur les zones d'appui 135 qui sont en silicium dans notre exemple. On pourra alors accroître la hauteur des saillies 130 par une gravure sélective du silicium vis-à-vis du germanium. Le film mince de germanium situé sur les zones d'appui 135 pourra éventuellement être éliminé avant l'étape d'épitaxie colonnaire.

On peut ainsi, par exemple, obtenir des saillies 130 d'environ 10 nanomètres de hauteur, deux saillies 130 voisines étant espacées d'environ 4 nanomètres et la période du réseau étant d'environ 20 nanomètres. On précise que la période correspond à l'intervalle formé d'une zone d'appui et de l'espacement qui la suit ou la précède.

En variante ou en combinaison, l'étape de révélation peut consister en un apport de budget thermique. Ce budget thermique peut être apporté sous forme d'au moins un recuit, éventuellement en présence de gaz particulier ou sous vide. Ce budget thermique a pour but de provoquer un changement de la topologie de la surface libre 111 du film mince 107 en faisant apparaître des saillies 130 et des creux qui dépendent de la topologie du réseau de défauts cristallins et/ou de champs de contraintes 114 qui se trouve au voisinage de l'interface 115, c'est-à-dire qui est enterré par rapport à la surface libre 111 du film mince 107.

D'autres méthodes peuvent être utilisées pour révéler le réseau de défauts cristallins et/ou de champs de contraintes 114 telles que l'introduction d'espèces chimiques dans le film mince 107 ou dans l'autre élément 108 par exemple par diffusion ou implantation ionique. L'introduction d'espèces chimiques peut cohabiter avec l'apport du budget thermique, cette introduction pouvant avoir lieu avant et/ou après et/ou pendant l'apport du budget thermique. Les espèces chimiques introduites peuvent être de l'or, du cuivre, du titane, de l'aluminium, ou un dopant par exemple du bore pour du silicium. Les espèces chimiques introduites se localisent au niveau des défauts et/ou des zones de contraintes maximales. Il est alors possible pour révéler le réseau de saillies d'utiliser par exemple une étape de gravure sélective.

La révélation peut également se faire par attaque chimique et/ou électrochimique et/ou ionique et/ou photochimique et/ou mécanique de l'élément aminci (film mince 107 ou élément 108). De la même manière cette attaque peut cohabiter avec l'apport du budget thermique, elle peut avoir lieu avant et/ou après et/ou pendant l'apport du budget thermique.

La ou les étapes d'attaque peuvent se faire sous diverses atmosphères oxydantes ou réductrices.

Il est possible également à ce stade, de modifier le réseau de saillies pour le rendre plus compatible, notamment en termes de paramètre de maille avec l'épitaxie à suivre. On pourra par exemple implanter les zones d'appui 135, avec du bore, de l'arsenic, du silicium, du germanium par exemple pour des saillies en silicium, de manière à élargir les zones d'appui, c'est-à-dire à augmenter leur surface. Cette implantation devra préserver néanmoins la qualité cristalline des zones d'appui pour assurer une qualité satisfaisante à l'épitaxie ultérieure. Cette implantation pourra être associée à une étape de diffusion des espèces implantées.

On peut alors procéder au dépôt du matériau à épitaxier, par exemple, du germanium. Dans ce cas, l'épitaxie peut être par exemple une épitaxie en phase gazeuse ou une épitaxie moléculaire (connue sous l'acronyme anglo-saxon MBE pour molecular beam epitaxy). Cette étape de dépôt, réalisée à une température de l'ordre de 600°C, est illustrée sur deux figures 2J et 2K, l'une correspondant au dépôt colonnaire et l'autre au dépôt de la couche continue une fois réalisée la jonction des colonnes.

Au début du dépôt, il se forme des colonnes 140 sur la zone d'appui 135 des saillies comme illustré sur la figure 2J. Le dépôt se poursuit et les colonnes 140 s'évasent, accroissent leur diamètre et finissent par se rejoindre. La couche continue 150 prend alors forme comme sur la figure 2K. Le matériau qui se dépose sur les saillies 130 va relaxer sa contrainte en modifiant le diamètre des colonnes 140. La mesure des paramètres de maille indique le taux de relaxation des contraintes du matériau déposé. Avec l'ajustement de l'angle de « twist » et la maîtrise de la formation du réseau de saillies 130, on va contrôler de manière très précise les paramètres géométriques des colonnes 140, c'est-à-dire leur section de base et leur espacement et ce à partir de la taille de la zone d'appui 135 des saillies 130, de leur hauteur 136 et de leur espacement 137. Avec la maîtrise de ces paramètres dimensionnels, on peut alors obtenir une couche continue 150 dont le taux de relaxation de ses contraintes est, par exemple, aussi grand que possible. La réalisation des colonnes 140 et donc de la couche continue 150 va pouvoir se faire de manière reproductible sur une surface entière de substrat de base sans à faire appel à des techniques longues et coûteuses de nanolithographie.

Dans une application de l'invention, la couche épitaxiée continue 150 obtenue pourra être transférée sur un autre substrat possédant ou non une relation cristallographique avec elle. L'autre substrat qui va recevoir la couche continue épitaxiée peut être par exemple en matière plastique, en verre, en un autre matériau cristallin, par exemple, semi-conducteur comme du silicium, en oxyde d'un matériau comme la silice ou même en carbure d'un matériau semi-conducteur comme le carbure de silicium. Ce transfert peut se faire par implantation d'espèces gazeuses aptes à fournir une zone fragile enterrée puis fracture au niveau de cette zone, par exemple, par traitement thermique et/ou mécanique comme décrit dans la demande de brevet FR-A-2 681 472.

On peut aussi par exemple, coller par adhésion moléculaire la face libre de la couche épitaxiée sur un substrat d'accueil et ôter le substrat initial sur lequel a eu lieu la croissance par un rodage, un polissage ou une attaque chimique appropriée. Une autre variante pourrait consister à utiliser un transfert mécanique pour transférer la couche épitaxiée, en profitant de la faiblesse induite par les espaces vides existants entre les colonnes sous la couche continue. Ces étapes ne sont pas représentées pour ne pas multiplier le nombre de figures.

Selon une variante de l'invention, pour réduire les coûts, il est possible de réaliser un seul exemplaire du substrat 2 ou 120 doté du réseau de saillies à l'échelle nanométrique comme on vient de le décrire aux figures 1 et 2 et de le dupliquer une ou plusieurs fois par une technique de lithographie par nanoimpression (connue sous l'acronyme anglo-saxon NIL soit nanoimprint lithography).

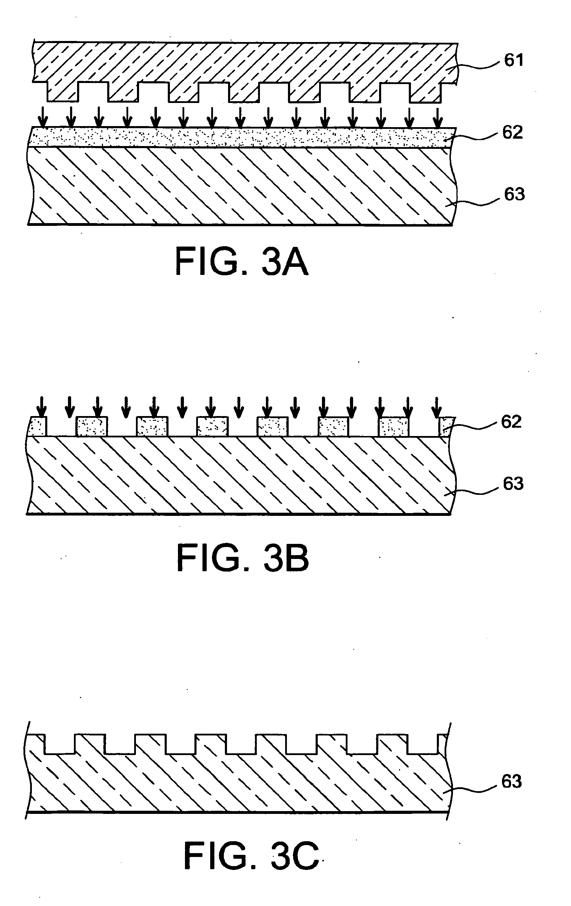

Cette technique consiste à réaliser un moulage du réseau de saillies du substrat 61 (appelé substrat mère) par une couche, par exemple, de résine 62 portée par un substrat 63 comme illustré sur la figure 3A. Ce report peut se faire, par exemple, par embossage à chaud ou exposition aux ultraviolets (figure 3B). On grave ensuite le substrat 63, qui est par exemple en silicium en se servant de la couche de résine 62 ajourée comme masque. La gravure peut être une gravure ionique (RIE). On obtient dans le substrat 63 un motif qui est le complémentaire de celui du réseau de saillies du substrat mère 61 et qui servira ultérieurement de moule. On se réfère à la figure 3C.

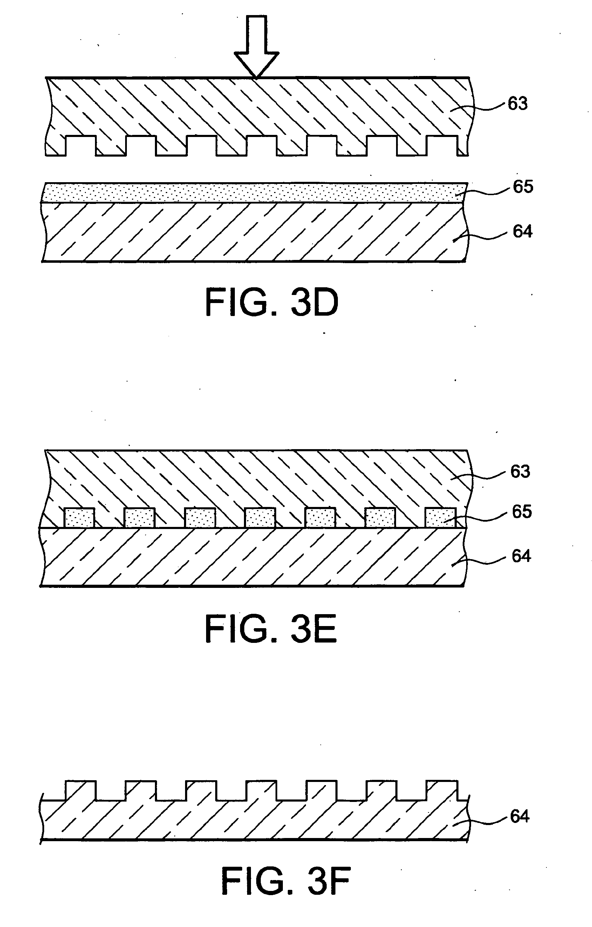

On recouvre ensuite un substrat cristallin 64 d'une couche, par exemple, de résine polymère 65. On laisse l'empreinte du moule 63 dans la couche de polymère 65, par exemple, par embossage à chaud ou exposition aux ultraviolets, comme illustré sur les figures 3D et 3E. On grave ensuite le substrat cristallin 64 à travers l'empreinte laissée dans la couche de résine polymère 65 comme illustré sur la figure 3F. On obtient alors une réplique du substrat mère 61 dotée d'un réseau de saillies sensiblement identique à celui substrat mère. Cette technique de lithographie par nanoimpression est décrite par exemple dans l'article « Replication of sub-40nm gap nanoelectrodes over an 8-in. Substrate by nanoimprint lithography » Tallal J. et al, Microelectronic engineering, 2005, vol.78-79 pages 676 à 681.

Bien que plusieurs modes de réalisation de la présente invention aient été représentés et décrits de façon détaillée, on comprendra que différents changements et modifications puissent être apportés sans sortir du cadre de l'invention telle que définie dans les revendications ci-jointes.

## Revendications

1. Procédé de réalisation d'une structure épitaxiée consistant à déposer un matériau par croissance épitaxiale colonnaire sur une face cristalline d'un substrat (2), à poursuivre le dépôt jusqu'à ce que les colonnes (4) se rejoignent et conduisent à une couche continue (5), **caractérisé en ce qu'**il consiste à pourvoir la face du substrat d'un réseau périodique de saillies (3) à l'échelle nanométrique, chaque saillie (3) présentant une zone d'appui (35) pour une colonne (4), et étant obtenue directement ou indirectement à partir d'un réseau de défauts cristallins et/ou de champs de contraintes créé au sein d'une zone cristalline (16) située au voisinage d'une interface (15) de collage entre deux éléments (11, 12) comprenant du matériau cristallin et ayant des réseaux cristallins décalés en rotation et/ou en flexion et/ou présentant un désaccord de paramètres de maille à l'interface, aptes à conditionner la période (38) du réseau de saillies (3), la période (38) du réseau, la hauteur (36) des saillies et la taille de leur zone d'appui (35) étant ajustées de manière que la couche continue (40) ait une épaisseur critique (39) supérieure à celle obtenue lors d'une épitaxie réalisée en l'absence des saillies.

2. Procédé selon la revendication 1, dans lequel le matériau déposé par épitaxie a un paramètre de maille naturel, **caractérisé en ce que** la période (38) du réseau, la hauteur (36) des saillies et la taille de leur zone d'appui (35) sont ajustées de manière que le matériau déposé par épitaxie ait retrouvé son paramètre de maille naturel au moment où les colonnes se rejoignent.

3. Procédé selon l'une des revendications 1 ou 2, **caractérisé en ce qu'**il consiste à réaliser le substrat (2) dont la face est dotée du réseau de saillies (3) à partir des deux éléments collés (11, 12), en amincissant l'un des éléments (11) jusqu'à faire apparaître un relief de surface correspondant réseau de défauts cristallins et/ou de champs de contraintes, ce relief formant alors le réseau de saillies, ce réseau de saillies (3) étant supporté par l'autre élément (12).

4. Procédé selon la revendication 3, **caractérisé en ce que** l'amincissement comprend au moins une étape choisie parmi une abrasion mécanique, une abrasion chimique, une rectification, un traitement sacrificiel.

5. Procédé selon l'une des revendications 1 à 4, **caractérisé en ce qu'**il comporte en outre une étape de traitement du réseau de saillies de manière à ajuster la hauteur (36) et/ou la taille de la zone d'appui (35) des saillies (3) et/ou à modifier le paramètre de maille du matériau constitutif des saillies (3).

6. Procédé selon la revendication 5, **caractérisé en ce que** l'étape de traitement du réseau de saillies (3) comprend une étape d'implantation.

7. Procédé selon l'une des revendications 3 à 5, **caractérisé en ce que** l'étape d'amincissement et/ou de traitement du réseau de saillies (3) comprend au moins une étape d'attaque chimique et/ou d'attaque électrochimique et/ou d'attaque mécanique et/ou d'attaque ionique et/ou d'attaque photochimique et/ou un dépôt, sous des atmosphères diverses oxydantes ou réductrices.

8. Procédé selon l'une des revendications 3 à 5, **caractérisé en ce que** l'étape d'amincissement et/ou de traitement du réseau de saillies (3) comprend l'apport d'un budget thermique.

9. Procédé selon l'une des revendications 1 à 8, **caractérisé en ce que** pour former les éléments, on prélève dans une même structure cristalline (100) au moins deux parties (108, 107), ces deux parties contribuant à la formation de l'interface (115) de collage.

10. Procédé selon la revendication 9, **caractérisé en ce que** lors du collage les deux parties ont leurs réseaux cristallins décalés en rotation et/ou en flexion d'un angle prédéterminé (θ).

11. Procédé selon la revendication 10, **caractérisé en ce que** la structure cristalline comporte des marques de repérage (105) qui sont reportées dans les deux parties (108, 107) lors du prélèvement, ces marques de repérage étant utilisées pour ajuster l'angle de décalage (θ).

12. Procédé selon l'une des revendications 1 à 11, **caractérisé en ce que** l'un au moins des éléments (110) est un substrat composite formé d'un empilement d'un support (106), d'une couche d'arrêt (102) à l'amincissement du support et d'au moins une couche cristalline (107).

13. Procédé selon la revendication 12, **caractérisé en ce que** l'étape d'amincissement concerne le substrat (110) composite.

14. Procédé selon l'une des revendications 12 ou 13, **caractérisé en ce que** le substrat composite est un substrat SOI.

15. Procédé selon l'une des revendications 12 à 14, **caractérisé en ce que** la partie prélevée (107) comprend au moins la couche cristalline.

16. Procédé selon l'une des revendications 1 à 15, **caractérisé en ce que** le collage se fait par adhésion moléculaire.

17. Procédé selon l'une des revendications 1 à 16, **caractérisé en ce que** la composition du matériau déposé varie pendant le dépôt par épitaxie.

18. Procédé selon la revendication 1, **caractérisé en ce que** le substrat (64) dont la face est pourvue du réseau de saillies est réalisé par duplication d'un substrat mère (61) dont une face comporte un réseau de saillies à l'échelle nanométrique, le substrat mère (61) étant obtenu à partir des deux éléments collés et par au moins une étape d'amincissement de l'un des éléments conduisant directement ou indirectement à une révélation du réseau de défauts cristallins et/ou de champs de contraintes, ce réseau de défauts cristallins et/ou de champs de contraintes formant le réseau de saillies.

19. Procédé selon la revendication 18, **caractérisé en ce que** la duplication se fait par nanoimpression à partir d'un moule (63) complémentaire du substrat mère (61).

20. Procédé selon la revendication 19, **caractérisé en ce que** le moule (63) est obtenu par nanoimpression à partir du substrat mère (61).

21. Structure épitaxiée comportant des colonnes (4) de matériau épitaxié s'évasant de manière à se rejoindre et à former une couche (5) continue, **caractérisée en ce que** chaque colonne (4) repose sur une zone d'appui (35) d'une saillie (3) d'un réseau périodique de saillies à l'échelle nanométrique dont est dotée une face d'un substrat (2), ces saillies (3) provenant directement ou indirectement d'un réseau de défauts cristallins et/ou de champs de contraintes, les saillies (3) du réseau ayant une période (38), une hauteur (36) et une taille de zone d'appui (35) ajustés de manière à ce que la couche continue (5) ait une épaisseur critique (39) supérieure à celle obtenue lors d'une épitaxie réalisée en l'absence des saillies.

## Claims

1. Method to produce an epitaxied structure consisting of depositing a material by columnar epitaxial growth on a crystalline face of a substrate (2), of continuing deposit until the columns (4) join together and lead to a continuous layer (5), **characterized in that** it consists of providing the face of the substrate with a periodic array of bumps(3) on a nanometric scale each bump (3) having a support zone (35) for a column (4), and being obtained directly or indirectly from an array crystalline defects and/or strain fields created within a crystalline region (16) located in the vicinity of a bonding interface (15) between two elements (11, 12) comprising crystalline material and having crystalline lattices with a twist and/or tilt angle and/or having interfacial lattice mismatch, able to condition the period (38) of the array of bumps (3), the period (38) of the array, the height (36) of the bumps and the size of their support zone (35) being adjusted so that the continuous layer (40) has a critical thickness (39) greater than the thickness obtained with an epitaxy conducted without the presence of bumps.

2. Method according to claim 1, wherein the material deposited by epitaxy has a natural lattice parameter, **characterized in that** the period (38) of the array, the height (36) of the bumps and the size of their support zone (35) are adjusted so that the material deposited by epitaxy has recovered its natural lattice parameter at the time the columns join together.

3. Method according to either of claims 1 or 2, **characterized in that** it consists of producing the substrate (2) whose face is provided with the bump array (3) from the two bonded elements (11, 12), by thinning one of the elements (11) until a surface relief is exposed corresponding to the array of crystalline defects and/or strain fields, this relief then forming the bump aray, this bump array (3) being supported by the other element (12).

4. Method according to claim 3, **characterized in that** thinning comprises at least one step chosen from among mechanical abrasion, chemical abrasion, grinding, sacrificial treatment.

5. Method according to any of claims 1 to 4, **characterized in that** it also comprises a step to treat the bump array so as to adjust the height (36) and/or size of the support zone (35) of the bumps (3) and/or to modify the lattice parameter of the constituent material of the bumps (3).

6. Method according to claim 5, **characterized in that** the treatment step of the array of bumps (3) comprises an implanting step.

7. Method according to any of claims 3 to 5, **characterized in that** the thinning step and/or treatment step of the array of bumps (3) comprises at least one chemical attack and/or electrochemical attack and/or mechanical attack and/or ionic attack and/or photochemical attack and/or depositing step, in various oxidizing or reducing atmospheres.

8. Method according to any of claims 3 to 5, **characterized in that** the thinning step and/or treatment step of the array of bumps (3) comprises the application of a heat schedule.

9. Method according to any of claims 1 to 8, **characterized in that,** to form the elements, at least two parts (108, 107) are taken from one same crystalline structure (100), these two parts contributing towards the formation of the bonding interface (115).

10. Method according to claim 9, **characterized in that,** during bonding, the crystalline lattices of the two parts are offset from a predetermined twist and/or tilt angle (θ).

11. Method according to claim 10, **characterized in that** the crystalline structure comprises locating marks (105) which are transferred to the two parts (108, 107) at the time they are taken, these locating marks being used to adjust the twist and/or tilt angle (θ).

12. Method according to any of claims 1 to 11, **characterized in that** at least one of the elements (110) is a composite substrate formed of a stack of a support (106), a stop layer (102) for thinning of the support and of at least one crystalline layer (107).

13. Method according to claim 12, **characterized in that** the thinning step concerns the composite substrate (110).

14. Method according to either of claims 12 or 13, **characterized in that** the composite substrate is a SOI substrate.

15. Method according to any of claims 12 to 14, **characterized in that** the part that is taken (107) comprises at least the crystalline layer.

16. Method according to any of claims 1 to 15, **characterized in that** bonding is molecular bonding.

17. Method according to any of claims 1 to 16, **characterized in that** the composition of the deposited material varies during epitaxial deposit.

18. Method according to claim 1, **characterized in that** the substrate (64) whose face is provided with the bump array is made by duplicating a mother substrate (61) of which one face comprises a bump array on a nanometric scale, the mother substrate (61) being obtained from the two bonded elements and by at least one thinning step of one of the elements, leading directly or indirectly to exposure of the array of crystalline defects and/or strain fields forming the bump array.

19. Method according to claim 18, **characterized in that** duplication is made by nanoimprinting from a mould (63) which matches the mother substrate (61).

20. Method according to claim 19, **characterized in that** the mould (63) is obtained by nanoimprinting from the mother substrate (61).

21. Epitaxied structure comprising columns (4) of epitaxied material flaring outwardly so that they join together and form a continuous layer (5) **characterized in that** each column (4) bears upon a support zone (35) of a bump (3) of a periodic bump array on a nanometric scale provided on one face of a substrate (2), these bumps being derived firectly or indirectly from an array of crystalline defects and/or strain fields, the bumps (3) of the array having a period (38), a height (36) and size of support zone (35) that are adjusted so that the continuous layer (5) has a critical thickness (39) that is greater than that obtained with epitaxy conducted without the presence of bumps.

## Patentansprüche

1. Verfahren zur Herstellung einer epitaxierten Struktur, darin bestehend, durch epitaxales Säulenwachstum ein Material auf einer kristallinen Vorderseite eines Substrats (2) abzuscheiden und die Abscheidung solange fortzusetzen, bis die Säulen (4) zusammenwachsen und eine kontinuierliche Schicht (5) bilden,
**dadurch gekennzeichnet, dass** es darin besteht, auf der Vorderseite des Substrats ein periodisches Gitter von Erhebungen (3) im nanometrischen Maßstab zu erzeugen, wobei jede Erhebung (3) eine Stützzone (35) für eine Säule (4) darstellt und direkt oder indirekt hergestellt wird mittels eines Kristallfehler- und/oder Spannungsfeldergitters, erzeugt im Innern einer kristallinen Zone (16), die sich in der Nähe einer Klebungsschnittfläche (15) zwischen zwei Elementen (11, 12) befindet, die kristallines Material umfassen und rotations- und/oder flexionsversetzt sind und dabei an der Schnittfläche eine Nichtübereinstimmung von Maschenparametorn aufweisen, die fähig sind, die Periode (38) des Gitters von Erhebungen (3) zu konditionieren, wobei die Periode (38) des Gitters, die Höhe (36) der Erhebungen und die Größe ihrer Stützzone (35) so adjustiert werden, dass die kontinuierliche Schicht (40) eine kritische Dicke (39) aufweist, die größer als diejenige ist, die man bei einer Epitaxie ohne das Vorhandensein der Erhebungen erhält.

2. Verfahren nach Anspruch 1, bei dem das durch Epitaxie abgeschiedene Material einen natürlichen Maschenparameter hat, **dadurch gekennzeichnet, dass** die Periode (38) des Gitters, die Höhe (36) der Erhebungen und die Größe ihrer Stützzone (35) so adjustiert werden, dass das durch Epitaxie abgeschiedene Material in dem Moment, wo die Säulen zusammenwachsen, seinen natürlichen Maschenparameter wiedergewonnen hat.

3. Verfahren nach einem der Ansprüche 1 oder 2, **dadurch gekennzeichnet, dass** es darin besteht, das Substrat (2), dessen Seite ein Gitter von Erhebungen (3) aufweist, aus zwei zusammengeklebten Elementen (11, 12) zu realisieren, indem man eines der Elemente (11) dünnt, bis ein dem Kristallfehler- und/oder Spannungsfeldergitter entsprechendes Oberflächenrelief erscheint, wobei dieses Relief dann das Erhebungen-Gitter (3) bildet und das andere Element (12) dieses Erhebungen-Gitter trägt.

4. Verfahren nach Anspruch 3, **dadurch gekennzeichnet, dass** die Dünnung wenigstens einen Schritt umfasst, der gebildet wird durch eine mechanische Abrasion, eine chemische Abrasion, ein Rektifizieren bzw. Feinschleifen, eine Opferungsbehandlung.

5. Verfahren nach einem der Ansprüche 1 bis 4, **dadurch gekennzeichnet, dass** es außerdem umfasst: einen Schritt zur Behandlung des Erhebungen-Gitters, um die Höhe (36) und/oder die Größe der Stützzone (35) der Erhebungen (3) zu adjustieren und/oder den Maschenparameter des die Erhebungen (3) bildenden Materials zu modifizieren.

6. Verfahren nach Anspruch 5, **dadurch gekennzeichnet, dass** der Behandlungsschritt des Erhebungen-Gitters (3) einen Implantationsschritt umfasst.

7. Verfahren nach einem der Ansprüche 3 bis 5, **dadurch gekennzeichnet, dass** der Dünnungs- und/oder Behandlungsschritt des Erhebungen-Gitters (3) wenigstens einen Schritt des Typs chemischer Angriff und/oder elektrochemischer Angriff und/oder mechanischer Angriff und/oder ionischer Angriff und/oder photochemischer Angriff und/oder eine Abscheidung umfasst, unter diversen oxidierenden oder reduzierenden Atmosphären.

8. Verfahren nach einem der Ansprüche 3 bis 5, **dadurch gekennzeichnet, dass** der Dünnungs- und/oder Behandlungsschritt des Erhebungen-Gitters (3) die Unterstützung bzw. Hilfe eines Wärmebudgets umfasst.

9. Verfahren nach einem der Ansprüche 1 bis 8, **dadurch gekennzeichnet, dass** man zur Bildung der Elemente einer selben kristallinen Struktur (100) wenigstens zwei Teile (108, 107) entnimmt, wobei diese beiden Teile zur Bildung der Klebungsschnittfläche (115) beitragen.

10. Verfahren nach Anspruch 9, **dadurch gekennzeichnet, dass** beim Zusammenkleben der beiden Teile deren Kristallgitter um einen vorherbestimmten Winkel (θ) rotations- und/oder flexionsversetzt sind.

11. Verfahren nach Anspruch 10, **dadurch gekennzeichnet, dass** die kristalline Struktur Bezugsmarken (105) umfasst, die bei der Entnahme in die beiden Teile (108, 107) übertragen werden, wobei diese Marken benutzt werden, um den Versetzungswinkel (θ) zu adjustieren.

12. Verfahren nach einem der Ansprüche 1 bis 11, **dadurch gekennzeichnet, dass** wenigstens eines der Elemente (110) ein Verbundsubstrat ist, gebildet durch einen Stapel aus einem Träger (106), einer Trägerdünnungs-Stoppschicht (102) und wenigstens einer kristallinen Schicht (107).

13. Verfahren nach Anspruch 12, **dadurch gekennzeichnet, dass** der Dünnungsschritt das Verbundsubstrat (110) betrifft.

14. Verfahren nach einem der Ansprüche 12 oder 13, **dadurch gekennzeichnet, dass** das Verbundsubstrat ein SOI-Substrat ist.

15. Verfahren nach einem der Ansprüche 12 bis 14, **dadurch gekennzeichnet, dass** der entnommene Teil (107) wenigstens eine kristalline Schicht umfasst.

16. Verfahren nach einem der Ansprüche 1 bis 15, **dadurch gekennzeichnet, dass** die Klebung eine molekulare Adhäsion ist.

17. Verfahren nach einem der Ansprüche 1 bis 16, **dadurch gekennzeichnet, dass** die Zusammensetzung des abgeschiedenen Materials während der Abscheidung durch Epitaxie variiert.

18. Verfahren nach Anspruch 1, **dadurch gekennzeichnet, dass** das Substrat (64), dessen Vorderseite das Erhebungen-Gitter aufweist, realisiert wird durch die Duplikation eines Muttersubstrats (61), bei dem eine Seite ein Gitter von Erhebungen im nanometrischen Bereich umfasst, wobei das Muttersubstrat (61) durch die beiden zusammengeklebten Elemente und durch wenigstens einen Schritt zur Dünnung eines der Elemente realisiert wird, was direkt oder indirekt zu einer Entwicklung des Kristallfehler-und/oder Spannungsfeldergitters führt, wobei dieses Kristallfehler- und/oder Spannungsfeldergitter das Erhebungen-Gitter bildet.

19. Verfahren nach Anspruch 18, **dadurch gekennzeichnet, dass** man die Duplikation durch Nanoprägung mittels einer Komplementärform (63) des Substrats (61) realisiert.

20. Verfahren nach Anspruch 19, **dadurch gekennzeichnet, dass** man die Form (63) durch Nanoprägung erhält, ausgehend von dem Muttersubstrat (61).

21. Epitaxierte Struktur mit Säulen (4) aus epitaxiertem Material, die sich so ausweiten, dass sie eine kontinuierliche Schicht (5) bilden, **dadurch gekennzeichnet, dass** jede Säule (4) auf einer Stützzone (35) einer Erhebung (3) eines periodischen Gitters von Erhebungen im nanometrischen Bereich ruht, mit denen eine Seite eines Substrats (2) versehen ist, wobei diese Erhebungen (3) direkt oder indirekt durch ein Kristallfehler-und/oder Spannungsfeldergitter verursacht werden und die Erhebungen (3) dabei eine Höhe (36) und eine Größe der Stützzone (35) aufweisen, die so adjustiert sind, dass die kontinuierliche Schicht (5) eine kritische Dicke (39) hat, die größer als diejenige ist, die man bei einer Epitaxie ohne das Vorhandensein der Erhebungen erhält.
